Europäisches Patentamt

European Patent Office

Office européen des brevets

(19)

(11) Numéro de publication: **0 203 923 B1**

# (12) FASCICULE DE BREVET EUROPEEN
## publi e en application de l'article
## 158, paragraphe 3 de la CC1

(45) Date de publication de fascicule du brevet:
**11.09.91**

(51) Int. Cl.5: **H03K 17/955**

(21) Numéro de dépôt: **85901013.4**

(22) Date de dépôt: **11.02.85**

(86) Numéro de dépôt internationale :
**PCT/FR85/00024**

(87) Numéro de publication internationale :
**WO 85/03820 (29.08.85 85/19)**

(54) PROCEDE POUR SCRUTER UN CLAVIER A TOUCHES CAPACITIVES ET UN CLAVIER ASSORTI DE MOYENS POUR SCRUTER UN CLAVIER SELON CE PROCEDE.

(30) Priorité: **16.02.84 FR 8402981**
**11.02.85 FR 8502021**

(43) Date de publication de la demande:
**10.12.86 Bulletin 86/50**

(45) Mention de la délivrance du brevet:
**11.09.91 Bulletin 91/37**

(84) Etats contractants désignés:
**DE GB**

(56) Documents cités:
**EP-A- 0 081 424**      **EP-A-00 232 71**
**DE-A- 3 025 841**      **FR-A- 2 271 538**
**GB-A- 2 080 536**      **GB-A- 2 080 990**
**GB-A- 2 090 979**      **GB-A- 2 119 931**
**US-A- 4 145 748**      **US-A- 4 263 659**
**US-A-36 964 09**

(73) Titulaire: **ANTIKIDIS, Jean-Pierre**
**30, avenue des Sources**
**F-31320 Castanet Tolosan(FR)**

Titulaire: **LOUIS, Frédéric**
**21, place Victor Hugo**
**F-31000 Toulouse(FR)**

(72) Inventeur: **ANTIKIDIS, Jean-Pierre**
**30, avenue des Sources**
**F-31320 Castanet Tolosan(FR)**
Inventeur: **LOUIS, Frédéric**
**21, place Victor Hugo**
**F-31000 Toulouse(FR)**

Rank Xerox (UK) Business Services

## Description

La présente invention est relative à un clavier à touches capacitives assorti d'un procédé pour la scrutation de ces touches.

On entend par scrutation le relevé systématique et exhaustif en fonction du temps de l'état de chaque touche.

Il existe un grand nombre de dispositifs à touches sensibles utilisant des effets capacitifs soit statiques, soit utilisant des techniques de scrutation et comparaison répétitive.

L'objet de la présente invention consiste en la combinaison judicieuse de dispositifs électronique et mécanique, destinée à résoudre parfaitement le problème spécifique de la communication homme / machine à travers une paroi diélectrique épaisse telle que vitrine de magasin, ceci sous forme d'un clavier de dimensions normales et au fonctionnement parfaitement fiable jusqu'à des épaisseurs de verre pouvant atteindre 30 mm.

Dans le cas où des claviers sont manipulés par différents opérateurs de façon intensive, par exemple téléphones publics, distributeurs automatiques de billets, claviers de renseignements ou autres, les dits claviers peuvent se détériorer à force de fausses manoeuvres répétitives, usure ou défaillance de pièces mobiles ou déformables constituant les touches, etc...

De plus dans le cas où on est obligé de manipuler des claviers avec les mains sales ou mouillées ou dans une atmosphère poussiéreuse, on risque de salir le clavier ou de laisser s'introduire de l'eau ou de la poussière dans les circuits associés à ce dernier.

La présente invention permet, entre autres, d'éviter ces inconvénients en proposant un clavier séparé de l'opérateur par une paroi diélectrique épaisse : ce dernier actionne les touches en posant son doigt en regard de la touche voulue et reçoit éventuellement un signal de validation visuel et/ou auditif lui permettant de constater son action.

Le clavier, selon l'invention, utilise comme indication d'activation l'effet capacitif dynamique créé sur un oscillateur électronique par le doigt de l'opérateur séparé des touches par la dite paroi et dont on analyse les variations de fréquences.

Le dit clavier peut être, en quelques secondes, apposé sur la dite vitrine à l'aide de moyen aussi simple que matériau adhésif double face, et, raccordé nême à distance notable (plusieurs mêtres) au dispositif électronique utilisateur à l'aide d'un cable dont le nombre de conducteurs reste réduit (de l'ordre de 5) et invariant quelque soit le nombre de touches inclues dans le clavier. Qui plus est, le susdit dispositif possède une logique interne programmée lui permettant d'émuler tout clavier traditionnel en fournissant des signaux standards (par exemple ASCII parallèle, RS232C etc...), ou encore en générant un signal dépendant d'une logique de déclenchement particulière (serrure codée).

Toutes ces applications peuvent être sélectionnées sans devoir modifier le matériel mais par simple choix du logiciel approprié.

Un tel clavier est conçu pour satisfaire à des applications de la vie quotidienne telles que : bureautique, informatique, matériel destiné à l'usage du grand public, manipulation à travers des vitrines de magasins pour information ou pour publicité, matériel de sécurité, à savoir serrure digitale pour portes, coffres ou voitures automobiles, claviers actionnés par des doigts mouillés ou sales, à savoir balance pour débiter des légumes, de la viande, du poisson, etc...

On conçoit parfaitement qu'un clavier destiné à être actionné à travers une paroi réponde à un besoin aujourd'hui grandissant et trouve une multitude d'applications dans tous les domaines où on utilise clavier et où on préférerait que l'opérateur n'ait pas de contact direct avec ce clavier pour des raisons de commodité, de sécurité, de contrôle et de fiabilité, ainsi que dans de nouveaux domaines comme la bureautique, l'informatique, l'information et la publicité à travers les vitrines, les serrures digitales pour portes, coffres, voitures automobiles, les systèmes de pesage industriels ou commerciaux.

En effet, par exemple, les techniques actuelles d'information et de publicité en vitrines utilisent des procé dés passifs, aucune interaction n'étant possible entre le chaland et les moyens d'information séparés par une vitre épaisse. La présente invention innove considérablement dans ce domaine de la communication à travers les vitrines en permettant un dialogue interactif entre le chaland dans la rue et des systèmes dans le magasin, contrôlés par le clavier.

L'originalité de la présente invention par rapport aux autres procédés capacitifs connus procède d'un procédé de scrutation qui rend son usage fiable malgré le faible effet capacitif introduit par l'application d'un doigt d'opérateur contre la touche a travers une paroi diélectrique d'une épaisseur allant jusqu'à plus de 15 mm. de verre courant. Cette fiabilité est aussi maintenue malgré un changement important de température à l'intérieur d'une vitrine exposée au soleil, à la pluie, à la neige.

Le dispositif décrit dans le présent brevet ne doit pas être confondu avec le système à écran tactile (brevet GB A 2 080 990) ou encore aux systèmes capacitifs sensibles au toucher (brevet USA 4 145 748) qui présument un contact physique du doigt de l'opérateur avec une surface conductrice éventuellement séparée de l'utilisateur par une épaisseur de diélectrique négligeable (quelques mm au plus), mais constitue un dispositif autonome installable de façon pratique et immédiate sur toute paroi diélectrique épaisse (jusqu'à plusieurs cm.) destinée à séparer l'utilisateur du système à commander. Le susdit dispositif délivrant des signaux parfaitement équivalents à un clavier mécanique à impulsion et ne nécessitant donc aucune précaution d'emploi particulière.

La difficulté du problème par rapport aux systèmes à touches capacitives classiques résulte de la variation infime de capacité à détecter lors de l'apposition d'un doigt face à une surface conductrice séparée par plusieurs centimètres de diélectrique. Compte tenu de la surface du doigt, la capacité rapportée pour 3 cm. de verre courant est de l'ordre de 0,1 pF alors qu'elle atteint plus de 10 pF pour les systèmes à touches sensibles classiques (brevet USA 4 145 748), voire 100 à 300 pF pour les systèmes utilisant un contact physique entre l'opérateur et une touche capacitive conductrice (brevet GB A 2 080 990). Les effets à détecter sont si faibles (cent fois plus faible que pour un clavier tactile), qu'ils n'avaient jusqu'à présent pas permis d'obtenir des dispositifs utilisables commercialement.

L'originalité du dispositif électronique utilisé procède du fait qu'il a été conçu de façon à permettre une sensibilité très élevée en optimisant et sélectionnant le choix des différentes solutions techniques utilisées et tout en conservant une très grande simplicité de mise en oeuvre, à savoir :

- Oscillateurs choisis pour leur fréquence de fonctionnement élevée, associés à une capacité d'accord très faible.
- Adressage séquentiel dans le temps des susdits oscilllateurs afin d'éviter toute interférence.
- Analyse des variations de fréquences par comptage de fréquences éliminant les imprécisions des systèmes à détection analogique d'amplitude (brevet F 82 01445).
- Evaluation d'une décision touche appuyée ou non en fonction de critères fournis par logiciel programmé et pouvant tenir compte de nombreux paramètres associés (épaisseur de diélectrique, sensibilité propre à chaque touche, historique des variations de fréquences enregistrées, etc...).

L'invention va être précisée par la description détaillée d'un mode de réalisation donné à titres d'exemple en référence aux dessins annexés en lesquels :

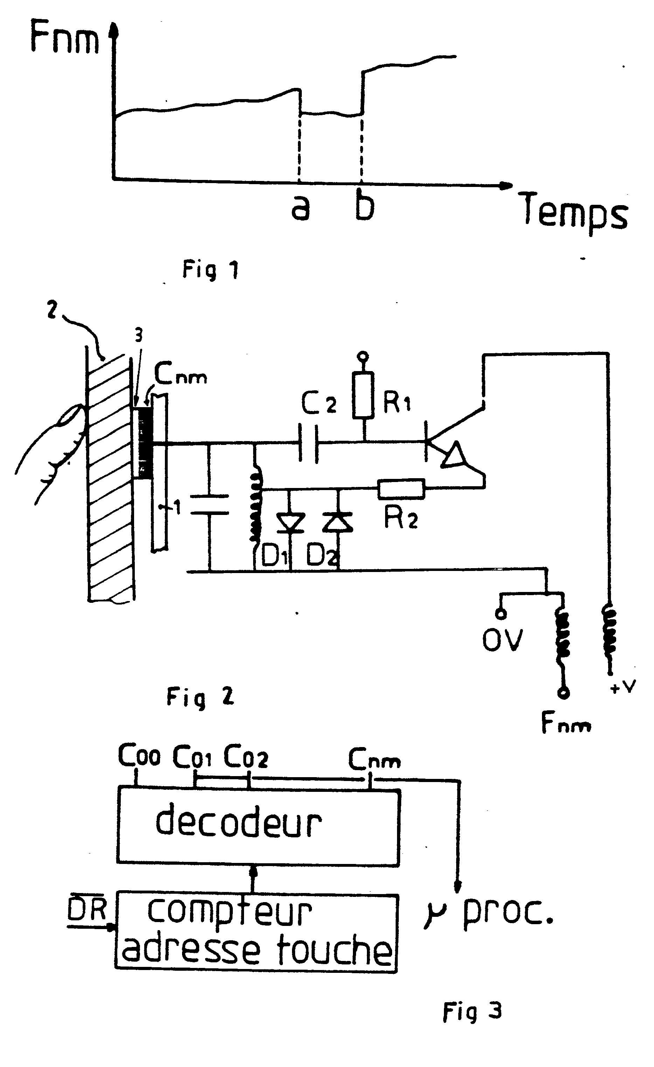

- La figure 1 est une courbe présentant le changement de la fréquence naturelle d'un oscillateur associé à une touche Cnm et ce changement lors de l'activation de cette touche.
- La figure 2 est le schéma de réalisation d'un oscillateur (donné à titre d'exemple) ce dernier est associé à une touche Cnm séparée du doigt de l'opérateur par une paroi diélectrique.

- La figure 3 est un schéma explicatif qui montre à titre d'exemple comment la sélection d'une touche peut être effectuée grâce à un signal logique périodique, à un compteur d'adresse des touches et à un décodeur, ce dernier émet cycliquement un signal de repère (dans le schéma, ce signal est relatif à la touche CO1).
- La figure 4 est un schéma explicatif du procédé et des moyens mettant en oeuvre ce procédé.

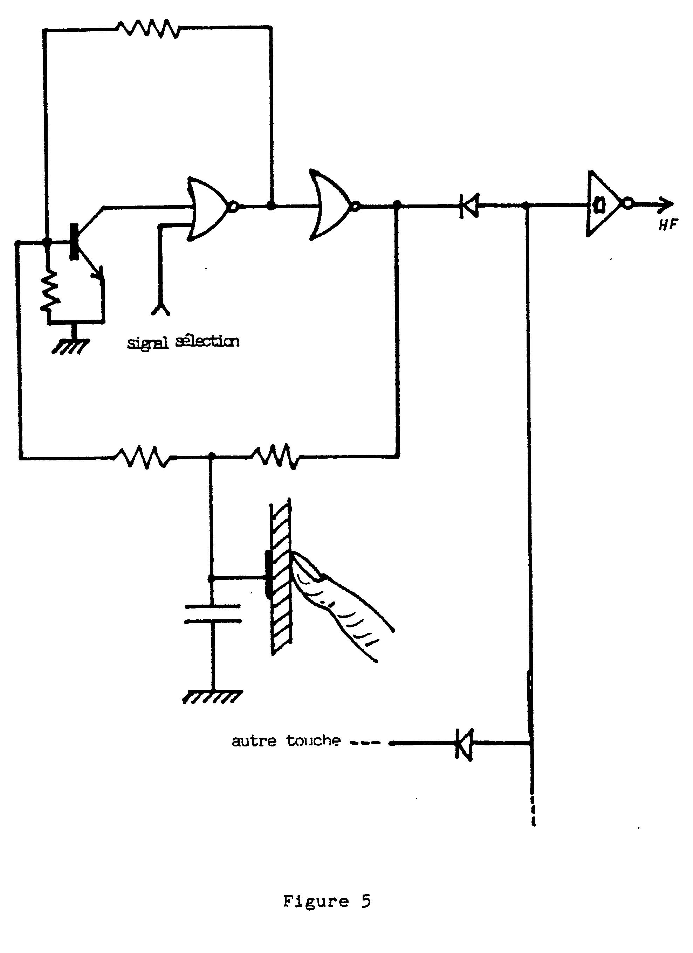

- La figure 5 présente un schéma d'oscillateur de type RC.
- La figure 6 présente l'architecture générale d'un système utilisant un clavier à touches activé à travers une vitrine.

La description qui suit est donnée à titre d'exemple d'une réalisation possible des principes revendiqués par l'invention et comprend :
Une réalisation mécanique avec :

- Un panneau de base (1) en matériau isolant électriquement doté d'électrodes Cnm disposées sur panneau, et formant les touches. Ce panneau de base pouvant être réalisé indifféremment en matière isolante rigide, molle ou souple.
- Une éventuelle couche en matériau diélectrique (3), de préférence adhésive, prévue pour porter des repères visuels identifiant ces touches, pouvant être fixée sur le panneau de base (1) ou placée d'un côté ou de l'autre de la paroi diélectrique (2) ci-après.
- Une paroi diélectrique (2) solidaire du panneau de base (1) ou non et, dans ce dernier cas, contre laquelle le panneau de base (1), et éventuellement la couche en matériau diélectrique (3), sont plaqués ; cette paroi diélectrique pouvant être selon le cas, transparente ou opaque.
- Les électrodes Cnm, la lettre n étant relative à une rangée et la lettre m étant relative à une colonne, réalisées en matière conductrice et pouvant porter elles-mêmes des des repères visuels identificateurs lithographiés ou réalisés avec tout autre moyen d'impression sur métaux.
- Les électrodes Cnm constituant les touches, étant associées chacune à un oscillateur libre ou commutées cycliquement à un oscillateur libre unique.
- Les électrodes Cnm présentent une capacité influençant la fréquence naturelle de l'oscillateur associé à cette touche ou l'oscillateur unique commuté cycliquement à la dite touche lorsqu'un corps formant un référentiel de masse, un doigt d'opérateur par exemple, est apposé à cette touche de l'autre côté de la paroi diélectrique. La surface des électrodes-touches pouvant être réduité à 0,5 cm² sans alteration des performances. de l'autre côté de la paroi diélectrique.

Le panneau de base (1) peut porter tout ou partie des éléments constituant le clavier et les moyens associés tels que les électrodes Cnm, le ou les ordinateurs, le microprocesseur, les circuits associés et les interfaces.

Les électrodes Cnm peuvent être intégrées dans la paroi diélectrique (2) lors de sa fabrication, dans cette dernière, les oscillateurs associés aux touches ou l'oscillateur unique peuvent être aussi intégrés.

Dans le cas où on intègre les touches et les oscillateurs dans la dite paroi, le panneau de base 1 est supprimé ou non. Les touches ainsi intégrées portent leur repère visuel.

De même on peut intégrer dans cette paroi, le microprocesseur programmé, les interfaces et des circuits associés.

Les éléments intégrés dans la dite paroi peuvent être regroupés ou non et dans ce dernier cas constituer, par exemple, un panneau de type carte, plan de ville ou similaire fixé contre une paroi vitrée, les touches étant disséminées derrière les centres d'intéret du dit panneau.

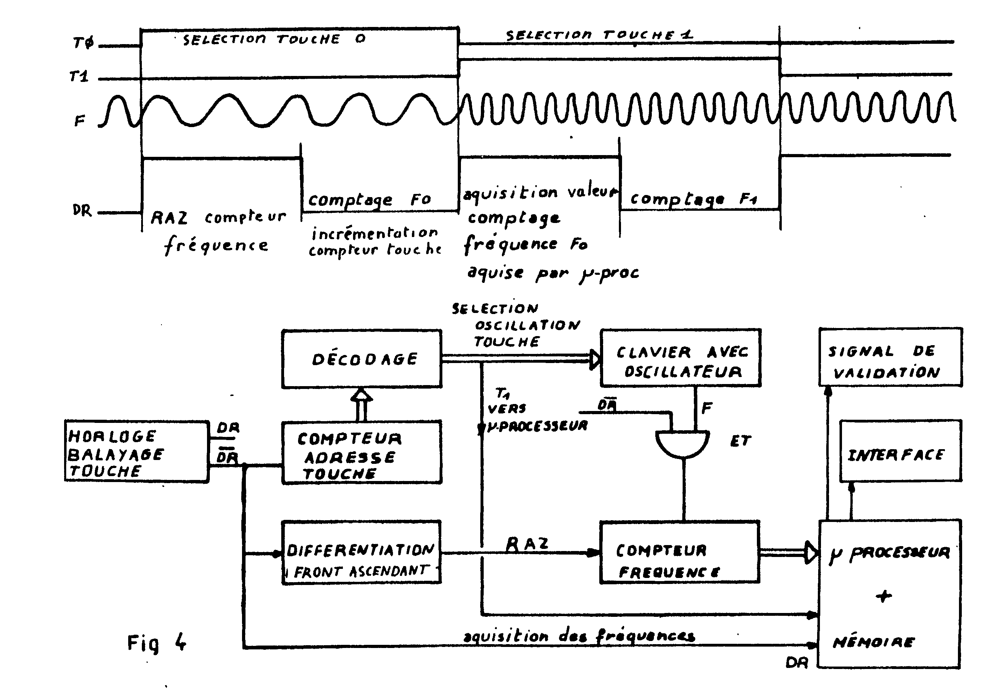

Une réalisation électronique comprenant (fig 4) :

A / Un système d'interface clavier comprenant :

- Un ensemble de circuits électroniques associés au clavier et comportant un oscillateur libre par touche. La fréquence d'un de ces oscillateurs étant influencée par l'approche d'un doigt face à la touche associée à cet oscillateur.

- Chacun des oscillateurs est mis en fonctionnnement à tour de rôle à l'aide de signaux logiques de sélection générés par un compteur et son décodeur associé.

- L'avantage d'une telle sélection temporelle par rapport aux techniques de multiplexage généralement employées est qu'à un instant donné un seul oscillateur est en fonctionnement ce qui interdit toute interaction entre les oscillateurs-touches (phénomènes connus sous le nom d'entraînment de fréquence ou bien encore battements indésirables). Par ailleurs, ce mode de fonctionnnement permet de réduire la consommation électrique du système qui, quelque soit le nombre de touches est réduit à la consommation d'une touche unique.

- Les oscillateurs-touches sont conçus pour présenter une fréquence de fonctionnement élevée, associée à une capacité d'accord aussi faible que possible (fréquence supérieure à 1 MHz, capacité d'accord inférieure à 5 pF, ceci afin de maximiser la variation de fréquence liée à une variation de capacité).

- Les sorties des oscillateurs-touches sont raccordées ensemble sachant que le mécanisme de sélection choisi ne permet qu'à une seule fréquence d'être présente à un instant donné ; cette sortie est dénommée HF (haute fréquence).

- Durant chaque période de signal $\overline{DR}$, un oscillateur associé à une touche donnée est sélectionné. Le signal HF présent en sortie est introduit vers un compteur appelé compteur fréquence qui compte pendant la durée du niveau haut du signal $\overline{DR}$ le nombre d'oscillations du signal HF.

- Dès que le signal $\overline{DR}$ parvient à l'état bas, le compteur fréquence est stoppé et ses sorties peuvent être analysées par un microprocesseur.

- Lorsque le signal $\overline{DR}$ repasse à l'état bas, le compteur fréquence est remis à zéro et le compteur touche incrémenté, d'où la sélection de la touche suivante.

- Le processus se répète de façon cyclique sachant que le compteur-touche repasse à zéro dès qu'il dépasse sa capacité de comptage propre (par exemple 16 touches peuvent être adressées avec un compteur 4 bits).

B / Un système à microprocesseur programmé qui reçoit sur ses entrées :

- Le signal $\overline{DR}$ qui indique à l'état bas que le compteur fréquence fournit une valeur proportionnelle (modulo la capacité de comptage de ce compteur) à la fréquence de l'oscillateur touche sélectionné. Pour chacune de ses transitions il indique au calculateur que la touche suivante vient d'être sélectionnée.

- Un signal $\overline{T1}$ qui est une sortie particulière de décodage du compteur touche correspondant à la sélection de la touche n°1. Ce signal permet au calculateur de se recaler.

- Les fils de sortie du compteur fréquence. En fonction de ces différents signaux, le calculateur con naît à tout instant le numéro de touche sélectionné et le moment où il peut accéder à la valeur de la fréquence associée à cette touche.

C / Un logiciel dit de base destiné à :

- Mémoriser de façon cyclique les fréquences associées à chaque touche.

- Décider en fonction de l'historique des variations de fréquence relative à une touche si elle a été actionnée ou non. La fréquence relative à une touche étant mesurée, à chaque cycle de scrutation, par le compte du nombre d'oscillations de l'oscillateur associé pendant la durée du niveau haut du signal DR.

non. Cette décision pouvant être non seulement basée sur une différence d'un passage à l'autre, mais également résulter d'un algorithme sophistiqué tenant compte, de l'épaisseur de diélectrique interposé, des variations de sensibilité différente pour chaque touche en égard aux dispersions des composants ou de tout autre paramètre jugé utile par le constructeur.

- Vérouiller le clavier pendant un certain temps afin d'éviter tout déclenchement intempestif en dehors des périodes prévues par le constructeur.

E /Un logiciel d'application destiné à :

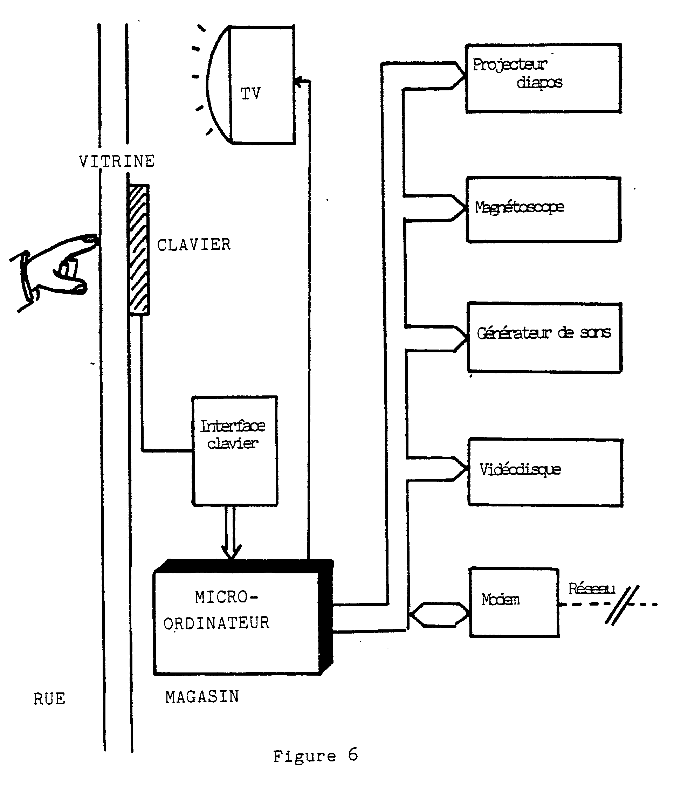

- Générer des signaux logiques ou analogiques, résultat de l'action sur le clavier, dont en particulier tous les cas de signaux standards normalisés pour claviers mécaniques clasiques (ASCII parallèle, RS232, etc...).
- Générer des signaux de sorties fonction d'une certaine séquence définie par l'utilisateur (serrures codées, accès à des zones de sécurité...).
- Mettre en oeuvre éventuelllement des systèmes extérieurs destinés à rendre compte ou répondre à la demande effectuée par l'opérateur (fig. 6) (télévision, magnétoscope, projecteur, etc...).

La présente invention décrite, ci-avant, marque un réel progrès par rapport à l'état des techniques actuelles, dont en particulier :

- La possibilité d'une technique entièrement nouvelle de communication à travers une paroi diélectrique, comme, par exemple, une vitrine de magasin en permettant, grace au clavier décrit ci-avant l'instauration d'un dialogue interactif à travers la vitrine entre le chaland et des moyens d'information contrôlés par le dit clavier.
- Les propriétés du dit clavier présentent dans certaines versions sous boitier vitré étanche à la fois, une fiabilité, une protection, une étanchéité à l'eau, aux poussières et aux atmosphères corrosives, accrues par rapport aux claviers actuels.
- Une autre propriété du dit-clavier, permettant, dans certaines versions et de par sa conception, une liaison filaire limitée à cinq fils et pouvant atteindre dix mêtres entre lui-même (touches, oscillateurs, circuits associés) et l'ensemble microprocesseur / Système micro-informatique de l'application.
- Une autre propriété du dit clavier permettant, dans certaines versions et de par sa conception, son installation ou déplacement aisés sur la paroi diélectrique, au moyen d'un simple ruban adhésif à double face.

**Revendications**

1. Clavier à touches capacitives conçu pour être utilisé à travers une paroi diélectrique épaisse et protectrice qui en est solidaire ou non et dans ce dernier cas, en vue d'une installation et d'un déplacement rapide au gré de l'utilisateur, dans la vitrine d'un magasin par exemple, est constitué par
   - Un panneau de base (1) en matériau isolant électriquement doté d'électrodes (Cnm) constituant les touches, ces dernières étant soit disposées sur ce panneau, soit intégrées dans ce panneau;
   - Une éventuelle couche (3) en matériau diélectrique couvrant toutes les touches, prévue pour porter des repères visuels identifiant ces touches;
   - Un ou plusieurs oscillateurs associés aux touches (Cnm);
   - Un ensemble de circuits électroniques destiné à gérer chaque oscillateur ainsi qu'à détecter la variation d'une des caractéristiques du signal généré par cet oscillateur lorsque le doigt de l'opérateur est apposé a une touche;
   - Un microprocesseur pour gérer le clavier et pour générer des signaux de sorties;

   Et caractérisé en ce que :
   a) Les touches sont séparées du doigt de l'opérateur par une épaisseur de diélectrique pouvant aller jusqu'à 30 mm;
   b) Qu'il ne comporte aucune électrode externe conductrice destinée à être touchée par l'opérateur;
   c) Qu'il utilise une série d'oscillateurs libres, c'est-à-dire dont la fréquence est influencée par l'approche du doigt de l'opérateur, activés par blocage / déblocage des susdits oscillateurs, ou bien un oscillateur libre unique commuté successivement sur chacune des touches, de telle sorte qu'un seul oscillateur libre est en fonctionnement à un instant donné;
   d) Qu'il utilise une technique d'analyse du signal basée sur l'utilisation d'un comptage des impulsions fournies par un oscillateur durant une periode fixe ce qui autorise un niveau de détectivité très élevée ainsi que requis par la caractéristique a), ceci à l'aide de circuits électroniques purement digitaux, donc directement interfaçables à un microprocesseur.

2. Clavier à touches capacitives selon la R1 caractérisé en ce que :

- La circuiterie électronique assure la génération d'un signal logique périodique rectangulaire ($\overline{DR}$) pour la sélection des touches, c'est-à-dire la sélection de l'oscillateur à activer, pour le comptage de sa fréquence, pour la remise à zéro cycliquement du précédent comptage et assure aussi l'émission d'un signal de repère;
- Le microprocesseur reçoit le comptage de fréquence, le signal cyclique de repère et le signal logique périodique rectangulaire ($\overline{DR}$) et émet d'une part un signal de validation lorsqu'une touche est activée et d'autre part des signaux soit pour commander différents types d'interface, soit pour interfacer des circuits postérieurs.

3. Clavier à touches capacitives selon la R1 caractérisé en ce que le choix de fréquences élevées (supérieures à 500 KHz) pour les oscillateurs de touche permet un fonctionnement fiable jusqu'à une épaisseur de la paroi diélectrique (2) atteignant 30 mm de verre courant.

4. Clavier à touches capacitives selon les R1, R2, R3 caractérisé en ce qu'un réglage immédiat et simple permet d'adapter le fonctionnement du clavier à l'épaisseur de la paroi diélectrique (2).

5. Clavier à touches capacitives selon les R1 et R2 caractérisé en ce que la circuiterie associée aux touches comprend un compteur d'adresse, un décodeur et les oscillateurs, et peut être reliee au microprocesseur par un câble limité à 5 fils et pouvant atteindre 10 mêtres de longueur.

6. Clavier à touches capacitives selon la R1, caractérisé en ce que le panneau de base (1 ) est fabriqué indifféremment en matière isolante opaque ou transparente , rigide, molle ou souple selon le besoin et en vue de l'adapter à différentes formes et/ou sortes de parois diélectriques (2).

7. Clavier à touches capacitives selon la revendication 1 caractérisé en ce que les touches (Cnm) portent elles-mêmes leur repère visuel identificateur, lithographié ou réalisé avec tous autres moyens d'impression sur métaux, ces repères ainsi réalisés pouvant être indifféremment isolants ou conducteurs sans pour autant perturber le fonctionnement des touches.

8. Clavier à touches capacitives selon la R1 caractérisé en ce que les électrodes (Cnm) constituant les touches sont intégrées avec leur repère visuel dans la paroi diélectrique (2).

9. Clavier à touches capacitives selon la R1 caractérisé en ce que les oscillateurs associés sont intégrés eux aussi avec les électrodes (Cnm) dans la paroi diélectrique.

10. Clavier à touches capacitives selon la R1 caractérisé en ce que les oscillateurs associés aux touches produisent des oscillations dont les fréquences peuvent varier dans une gamme relativement Large tout en restant compatibles avec les circuits associés de mesure et de traitement de fréquence, cette caractérisation facilitant la production en grande série à prix réduit.

11. Clavier à touches capacitives selon la R1 caractérisé en ce que la Couche (3) est placée selon le besoin sur la paroi diélectrique et en face du clavier d'un côté ou de l'autre de la dite paroi ou tout simplement sur les touches elles-mêmes, cette couche (3) étant isolante et de préférence adhésive.

12. Clavier à touches capacitves selon la R1 caractérisé en ce qu'un oscillateur libre unique est commuté cycliquement aux dites touches pour remplacer les oscillateurs qui leur sont associés et activés cycliquement.

13. Dispositif à touches capacitives selon la R1 dans lequel la Couche (3) est remplacée par un panneau de type carte, plan de ville ou similaire fixé contre une paroi vitrée et caractérisé en ce que les touches sont disposées derrière les centres d'intérêt du dit panneau de façon à permettre l'établissement d'une relation entre l'opérateur situé de l'autre côté de la paroi diélectrique et les dits centres d'intérêt.

14. Procédé pour scruter le clavier à touches capacitives selon la R1, dans lequel chaque touche est associée à un oscillateur libre ou commutée cycliquement à un oscillateur libre unique caractérisé en ce qu'il comprend les étapes suivantes :
    - Générer des signaux logiques de scrutation des touches, cette étape comportant les phases suivantes :
    a) Produire un signal logique périodique ($\overline{DR}$) destiné à être utilisé pour sélectionner chacune des touches à tour de rôle, soit en sélectionnant et faisant fonctionner successivement les oscillateurs associés chacun à une touche, soit en commutant l'oscillateur unique successivement et cycliquement sur chaque touche, la durée de sélection d'une touche étant synchrone du signal $(\overline{DR})$.

b) Compter pendant une phase de comptage déclenchée par un changement d'état du signal logique $(\overline{DR})$ le nombre d'oscillations de l'oscillateur associé à chaque touche lors de la sélection de la dite touche.

c) Remettre à zéro le comptage du nombre d'oscillations, une fois que celui-ci est pris en compte.

d) Emettre un signal de repère correspondant à une sélection d'une des touches, pour permettre d'identifier toutes les autres touches en prenant cette touche comme repère.

e) Acquérir et mémoriser pendant une phase d'acquisition postérieure à celle du comptage, le nombre d'oscillations de l'oscillateur associé à chaque touche.

- Comparer pour chaque touche le compte du nombre d'oscillations de l'oscillateur associé avec les comptes précédents pour la même touche.

- Décider si une touche est activée ou non, cette décision étant basée sur un algorithme utilisant des comptes de nombre d'oscillations relatifs à la même touche.

- Emettre éventuellement un signal auditif et/ou visuel du signal de validation permettant à l'opérateur de constater son action.

- Générer des signaux normalisés pouvant commander différents types d'interface et notamment les interfaces standard courant.

15. Procédé selon la Revendication 14 caractérisé en ce que la décision si une touche est activée ou non est prise selon les étapes suivantes :

- Comparer chaque comptage de nombre d'oscillations pour une touche donnée au comptagè ou aux comptages précédents correspondant à la même touche et conclure s'il y a changement du nombre d'oscillations à considérer ou non en fonction d'un algorithme adapté tenant compte des limites prédéfinies par le concepteur en particulier de l'épaisseur de la paroi diélectrique.

- Vérifier la cohérence de l'action détectée vis à vis des limites prédéfinies par le concepteur.

- Emettre si les deux tests précédents sont positifs un signal dè retour auditif et/ou visuel associé à la génération des signaux soit commandant différents types d'interfaces, soit interfaçant des circuits.

16. Clavier à touches capacitives selon la R1 caractérisé en ce qu'il utilise des oscillateurs libres accordés par résistance et capacité et dont la capacité d'accord est réduite à une valeur très faible, inférieure à 5 pf.

17. Clavier à touches capacitives selon la R1 caractérisé en ce qu'il utilise un microprocesseur pouvant analyser l'historique des variations de fréquences enregistrées sur plusieurs cycles ceci à l'aide d'algorithmes décisionnels modulables par le concepteur et non pas limités à de simples soustractions.

18. Clavier à touches capacitives selon la R1 caractérisé en ce qu'il peut être raccordé par un nombre de fils réduits, de l'ordre de 5, ne dépendant pas du nombre de touches du susdit clavier.

19. Clavier à touches capacitives selon la R1 caractérisé en ce que la surface de touches peut être réduite jusqu'à 0,5 cm$^2$ sans altération des performances.

20. Clavier à touches capacitives selon la R1, caractérisé en ce que le micro-processeur programmé peut générer des signaux de commande dépendant d'une logique d'action sur les touches.

21. Clavier à touches capacitives selon la R1 caractérisé en ce qu'il utilise un interface électronique raccordé aux oscillateurs touche par un nombre de fils réduits et susceptibles de gérer par simple modification de logiciel un nombre de touches variant de 1 à 64.

22. Clavier à touches capacitives selon la R1 caractérisé en ce que les électrodes actives (Cnm) sont mécaniquement désolidarisées de la surface diélectrique les séparant de l'utilisateur, ce qui permet une installation ou un déplacement aisé et immédiat du dispositif.

**Claims**

1. Keyboard with capacitive keys designed in view of beeing utilized trough a thick and protective dielectric wall removable or not, and in that later case, allowing an easy and quick installation by the user, for example in a shop window, comprising:

- A supporting panel (1) made of insulative material and covered with electrodes (Cnm) contituting the keys which are either deposited or integrated within the panel;
- Whenever needed, a dielectrical layer (3) covering all keys, in view of presenting any visual sign associated to the key;
- One or several oscillators associated to the keys (Cnm);
- An electronic circuit able to drive each oscillator and able to detect the signal variation of this oscillator when the user'finger is presented to a key;
- A microprocessor controlling the keyboard and generating output signals; And characterized by the fact that:

a) The keys are separated from the user'finger by a dielectric thickness of up to 30mm;

b) It does not make use of any conductive external electrodes to be touched by the user;

c) It utilizes a set of free running oscillators, it's to say which frequency is influenced by the user'finger approach, activated by blocking/unblocking of said oscillators, or using a single free running oscillator sequentialy switched onto each key, in such a way as only one oscillator is active at a given time;

d) It utilizes a signal analysis procedure based on the counting of the number of pulses delivered by an oscillator during a fixed period of time enabling a very high detectivity level as required by characteristic a), this beeing performed with the help of a purely digital electronic, hence directly compatible with a micro-processor.

2. Keyboard with capacitive keys of R1 and charactarized by the fact that:

- The electronic circuit generates a periodic and rectangular logic signal ($\overline{DR}$) for the keys selection, it is to say the selection of the oscillator to be activated , for the frequency counting, for the cyclic reset of the preceeding counting and the emission of a reference signal;
- The microprocessor receives the frequency counting, a cyclic reference signal and the periodic rectangular logic signal ($\overline{DR}$), and output on one hand a validation signal whenever a key has been activated and on the other hand any necessary signals either to command different interfaces, or to interface complementary circuits.

3. Keyboard with capacitive keys of R1 and characterizd by the choice of high frequencies (beyond 500 KHZ) for the keys oscillators enabling reliable operations for a dielectric wall (2) reaching 30 mm of conventional glass.

4. Keyboard with capacitive keys of R1,R2, R3 and characterizd by the fact that a quick and straightforward tuning allows the matching of the keyboard fonctionning to the dielectric wall (2) thickness.

5. Keyboard with capacitive keys of R1 and R2 and characterized by the fact that the circuit associated to the keys comprises an adress counter, a decoder and the oscillators, and is connected to the microprocessor with the help of a cable limited to 5 wires with a lenght that may reach 10 meters.

6. Keyboard with capacitive keys of R1 and characterized by the fact that the supporting panel (1) can be indifferently made out of insulating material, transparent or not, rigid , soft or flexible, depending on the need to match any pattern or kind of dielectric walls (2).

7. Keyboard with capacitive keys of R1 and characterized by the fact that the the keys (Cnm) are embedded with their own visual label, lithographed or deposited by any other means of metal impression, those labels beeing made conductive or not without affecting the proper fonctionning of the keys.

8. Keyboard with capacitive keys of R1 and characterized by the fact that the electrodes (Cnm) of the keys and their label are integrated within the dielectric wall (2).

9. Keyboard with capacitive keys of R1 and characterized by the fact that the associated oscillators and the electrodes (Cnm) are also integrated in the dielectric wall.

10. Keyboard with capacitive keys of R1 and characterizd by the fact that the oscillators associated to the keys generate oscillations which frequencies can relatively largely vary and still be compatible with the measuring and processing capability of the associated circuits, such feature allowing a large scale production at low cost.

11. Keyboard with capacitive keys of R1 and characterized by the fact that the layer (3) is, depending on the need, placed on the dielectric wall facing the keyboard on either side of the said wall or simply deposited on the keys, such layer (3) beeing non conductive and preferably adhesive.

12. Keyboard with capacitive keys of R1 and characterizd by the fact that only one oscillator is repeatedly commutated to the said keys as a replacement for the set of associated oscillators repeatedly activated.

13. Keyboard with capacitive keys of R1 and characterized by the fact that the layer (3) is replaced by a panel showing a map, a town-map or anything similar fixed against a glass panel and further characterized by keys beeing placed behind spots of interest in the said panel, enabling an interaction in between the user on the other side of the dielectric pannel and these spots of interest.

14. Mean to scan the Keyboard with capacitive keys of R1, in which each of the keys is associated to a free running oscillator or repeatedly commutated to a single free running oscillator and charactarized by following steps:
    - Generation of the logic signals for the scanning of the keys, comprising the following phases:
      a) Generation of a periodic logic signal $(\overline{DR})$ to be utilized for the one by one keys selection, either by selecting and running sucessivly each of the oscillators associated to a given key, or by commutating a single oscillator sucessively and repeatedly onto each key, the duration a key selection beeing phased with signal $(\overline{DR})$.
      b) Count during a counting phase triggered by a change in the logic signal (DR), the number of oscillations of the oscillator associated to each key during its selection time.
      c) Reset to zero the count of oscillations once it has been acquired.
      d) Output a reference signal corresponding to the selection of one particular key and enable the identification of the other keys with the help of this reference.
      e) Acquire and memorize during the acquisition phase following the counting, the number of oscillations associated to each key.
    - Compare for each of the keys the count of the number of oscillations of the associated oscillator with the preceeding counts associated to the same key.

    - Decide whether a key is activated or not, such decision beeing based on an algorithm utilizing the oscillations counts associated to the same key.
    - If needed, emit an audio and/or visual validation signal warning the operator.
    - Output normalized signals able to control different type of interfaces among which the standard ones.

15. Mean of claim 14 and characterized by the decision, on whether a key is activated or not, beeing based on the following phases:
    - Compare for each count of number of oscillations for a key the preceeding counts and determine whether there has been a significant change or not with respect to a suitable algorithm taking care of design parameters among which the dielectric wall thickness.
    - Check the coherency of the detected action vis a vis design limits.
    - Should above two tests be positive then generate a return audio and/or visual signal as well as signals commanding different types of interfaces or interfacing other circuits.

16. Keyboard with capacitive keys of R1 and characterized by the fact that it makes use of free running oscillators, tuned by resistance and capacitance, which tuning capacitance is keept very low, typically below 5pf.

17. Keyboard with capacitive keys of R1 and characterized by the fact that it makes use of a microprocessor able to analyse the history of the frequencies variations over several cycles, this with the help of decisional algorithms which can be modified by the designer and not only limited to simple substractions.

18. Keyboard with capacitive keys of R1 and characterized by the fact that it can be connected with the help of a limited number of wires, around 5, not dependant to the number of keys of said keyboard.

19. Keyboard with capacitive keys of R1 and characterized by the fact that the surface of the keys can be reduced to 0.5 cm2 without hampering the performances.

20. Keyboard with capacitive keys of R1 and characterized by the fact that the programmed microprocessor can generate commanding signals resulting from a logic of action on the keys.

21. Keyboard with capacitive keys of R1 and characterized by the fact that it makes use of an electronic interface connected to the key oscillators with the help of a reduced number of wires and able to monitor by only software modifications a number of keys varying from 1 to 64.

22. Keyboard with capacitive keys of R1 and characterized by the fact that the electrodes (Cnm) are mechanically independant from the dielectric separating wall, thus allowing an easy and quick installation and displacement for this device.

## Patentansprüche

1. Die Tastatur mit kapazitiven Tasten entworfen um benützt zu werden quer durch eine dicke dielektrische Schutzwande, solidarisch oder nicht, und in diesem letzten Fall in der Optik einer schnelle Einstallation und Umstellbarkeit nach belieben des Gebrauchers, in der Vitrine eines Ladens zum Beispiel, ist gebildet von:
   - Ein Basenbrett (1) in elektrisch isolierender Baustoff, angestattet mit Elektroden bildende Tasten (Cnm). Diese Tasten sind auf dem Brett angeordnet oder im Brett integriert;
   - Ein eventueller Uberzug in dielektrischer Baustoff die alle Tasten bedeckt, und berechnet ist um ein visuales Identifikationszeichen zu tragen;
   - Ein oder mehrere Oszillatoren verbunden mit der Tasten (CNM);
   - Eine Gesamtheit von elektronische Schaltungen fur die Verwaltung jeder Oszillatoren und für die Aufspührung der Variation von einer der Signalkarakteristiken, hervor gebracht von diesem Oscillator wenn der Finger eines Operators die Taste berührt;
   - Ein Microkontrolleur für die Verwaltung der Tastatur und um die Ausgangsignale hervor zu bringen;
   Dei Die Tatstatur ist karakterisiert von:
   a) Die Tasten sind getrennt vom Finger des Operators von einer bis zu 30 mm dielektrische Dicke;
   b) Die Tastatur hat keine auswendige leitfähige Elektroden die angerührt werden kan beim Operator;
   c) Die Tastatur benutz eine Serie von freien Oszilatoren. Das heisst das ihre Frequenze beeinflusst ist von dem nährenden Finger des Operators und aktiviert, bei weder Verreglung / Offnung der Oszillatoren oder eine allmähliche Umschaltung von einer einzige freie Oszillator auf jeden der Taste, so das nur ein einziger freier Oszillator fonktionniert in eimen bestimmten Moment;
   d) Die Tastatur benützt eine technische Signalanalyse basiert auf der Benützung eines Impulszählers hervor gebracht von einem Oszillator während eine bestimmte Periode Dieses System erlaubt ein sehr hohes Detektionsniveau wie notwendig für die Karakteristik a) vermittels ausschliesliche elektronische Digitalschaltungen, also unmittelbar verbindungsbereit mit einem Microkontrolleur.

2. Die Tastatur mit kapazitiven Tasten wie in R1, karakterisiert von:
   - Die elektronische Schaltung bringt hervor ein logischer Signal, periodisch rechtwinkelig, (DR) für die Auswahl der Tasten, das heisst die Auswahl des Oszillators der aktiviert werden soll, für den Zähler seiner Frequenz, für die zyklische Rückstellung am Nullpunkt der vorigen Zähler, und sie sichert auch die Sendung des Merkzeichensignals;
   - Der Microkontrolleur empfangt die Frequenzzahle, den zyklischen Zeichensignal und den logischen Signal, periodisch rechtwinkelig, und sendet ausser einen Bestätigungssignal wenn eine Taste aktiviert worden ist, auch die Signale entweder um die verschiedene Peripherieschaltungen zu steuern, oder um Verbindungen her zu stellen mit hintere auswendige Peripherien.

3. Die Tastatur mit kapazitiven Tasten wie in R1, karakterisiert von:
   Der Wahl der höheren Frequenzen (höher als 500 KHz) für den Tastenoszillatoren sichert ein zuferlässiges Fonktionieren bis eine 30 mm dicke dielektrische Normalglaswande (2).

4. Die Tastatur mit kapazitiven Tasten wie in R1, R2 und R3 karakterisiert von:
   Eine sofortige und einfache Einstellung erlaubt eine Anpassung des Fonktionnieren der Tastatur an die Dicke der dielektrische Wande (2).

5. Die Tastatur mit kapazitiven Tasten wie in R1 und R2 karakterisiert von:
   Die Schaltung assoziiert mit den Tasten umfast ein Adressenzähler, ein Dekodierer und die Oszillatoren und kann verbunden werden am Microkontrolleur mit einem bis 10 meter lange fünfaderige Kabel.

6. Die Tastatur mit kapazitiven Tasten wie in R1, karakterisiert von:
Das Bret ist verfergtigt unterschiedlos in durchsichtlichen oder undurchsichtichen, starren, weichen oder biegsamen Baustoff in übereinstimmung mit dem Bedürfnis und in einer Anpassungsoptik der verschiedene Formen und/oder Sorten der dielektrische Wande.

7. Die Tastatur mit kapazitiven Tasten gemäss die Forderung 1:
Die Tasten (CNM), tragen selbst ihre visuale Identifikationszeichen, lithographiert oder ausführbar mit allen anderen Metalabdruckmitteln. Die Merkzeichen so erschaft können unabhängig isoliert oder leitunggebent sein ohne das Tastenfonktionieren zu stöhren.

8. Die Tastatur mit kapazitiven Tasten wie in R1, karakterisiert von:
Die Elektroden (Cnm) die die Tasten formen sind auch integriert in der dielektrische Wande (2) mit ihren visualen Kenzeichen.

9. Die Tastatur mit kapazitiven Tasten wie in R1, karakterisiert von:
Die assoziierte Oszillatoren sind auch integriert in der dielektrische Wande mit den Elektroden (Cnm).

10. Die Tastatur mit kapazitiven Tasten wie in R1, karakterisiert von:
Die Oszillatoren assoziiert mit den Tasten produzieren Oszillationen dessen Frequenze variieren können in einem verhältnismassig weiten Bereich aber sie bleiben vereinbar mit den assoziierte Messungs- und Frequenzbehandlungschaltungen. Diese Karateristik erleichtert die serienmässige Herstellung mit ermässigten Preise.

11. Die Tastatur mit kapazitiven Tasten wie in R1, karakterisiert von:
Der Uberzug ist angebracht je nachdem dem Bedürfnis auf der dielektrische Wande und gegenüber die Tastatur, einer oder anderseits der Wände oder einfachweise auf den Tasten selbst. Der Uberzug ist isolierent und vorzugsweise klebrig.

12. Die Tastatur mit kapazitiven Tasten wie in R1, karakterisiert von:
Ein einziger freier Oszillator ist zyklischerweise umgeschalten auf die Tasten um den Oszillatoren die mit ihr verbunden sind und zyklischerweise aktiviert sind, zu ersetzen.

13. Die Anlage mit kapazitiven Tasten wie in R1, karakterisiert von:

Der Uberzug ist ersetz durch ein Plakat der Type Karte, Stadtplan oder gleichartig, befestigt gegen eine verglaste Wande. Die Tasten sind angeordnet hinten dem Interessengebiet der Wande, dergestelt um die Begründung einer Beziehung zu erlauben zwischen der Operator, placiert auf die andere Seite der dielektrische Wande und die Interessengebieten.

14. Erforschungsmethode der Tastatur mit capacitiven Tasten wie in R1, karakterisiert von:
Jede Taste ist assoziiert mit einem freien Oszillator oder ist zyklisch umgeschalten auf einem einzigen freien Oszillator. Die Erforschungsmethode ist karakterisiert von der Umfassung nächster Stufen:

- Herstellung logischer Erforchungsignale der Tasten, diese Stufe erfördert die nächste Phasen:

a) Die Herstellung eines periodisches logisches Signal (DR) bestimmt für eine Selektion jeder Tasten der Reihe nach, durch eine Auswahl und ein fortwährendes Fonktionieren des mit einer Tasten assoziierten Oszillatoren, oder durch die fortwährende und zyklische Umschaltung auf jeder Tasten der unike Oszillator. Die Selektionsdauer einer Taste ist synchron mit dem Signal (DR).

b) Die Zählung während einer Zählphase ausgeslöst von einer Veränderung des logisches Signalstatuts (DR) der Oszillationszähl assoziiert mit jeder Taste während die Selektion der Taste.

c) Die Rückstellung am Nullpunkt des Zählers der Oszillationszähl, einmahl das diese Zähl in Angriff genommen ist.

d) Die Aussendung eines Kenzeichens das korrespondiert mit einer Tastenselektion um eine Identifikation aller anderen Tasten zu erlauben ab diese Taste als Markierung.

e) Der Erwerb und Memorisation der Oszillationzähl des Oszillateurs assoziiert mit jeder Taste während einer Entwerbphase nachher die Zählphase.

- Die Vergleichung für jede Taste die Oszillationzähl des Oszillateurs assoziiert mit den vorgehenden Zählern für jede Taste.

- Die Entscheidung weder eine Taste activiert ist oder nicht, ist basiert auf einem Algorithmus benützt vom Oscillatorzähler, verbunden mit derselbe Tastet.

- Die eventuelle Sendung eines Auditives und/oder visuales Bestätigungssignal. Dieser Signal erlaubt den Operator seine Aktion zu konstatieren.

- Das Hervorbringen normalisierte Signale die verschiedene peripherie-typen befehlen können und insbesonders die übliche Standardperipherien.

15. Vorgehen wie die Forderung 14, karakterisiert von:
Die Entscheiding ob eine Taste aktiviert worden ist oder nicht ist in den folgenden Stufe genommen:
   - Eine Vergleichung jedes Zählers der Oszillationszähle für eine bestimmte Taste oder des vorgehenden Zählers derselbe Taste, und erkennen ob Änderungen der Oszillationszahle betrachtet werden muss oder nicht folgens einer adaptierte Algorythmus abhänglich der Beschränkungen definiert von dem Konzepteur, und besonderes die Dicke der dielektische Wande.
   - Nachprüfung der Zusammenhang der aufgespürte Aktionen gegenüber die Beschränkungen definiert von dem Konzepteur.
   - Die Sendung, wenn die 2 vohrere Tests positif sein, eines auditives oder visuelles Signal, assoziiert mit der Hervorstellung Signales die weder verschiedene Peripherietypen kommandieren, oder verbunden sind mit auswendige Peripherien.

16. Die Tastatur mit kapazitiven Tasten wie in R1, karakterisiert von:
Die Benützung freien Oszillatoren harmonisiert mit Wiederstand und Kapazität, deren Harmonisierkapazität reduziert ist bis eine sehr schwache Werte, weniger als 5 pf.

17. Die Tastatur mit kapazitiven Tasten wie in R1, karakterisiert von:
Die Benützung eines Microkontrolleurs ermöglicht die Analysierung der Geschichte der Frequenzvariazionen, registriert während mehrere Zyklus vermittels entscheidungsfähige Algorythmus, modifizierbar vom Konzepteur und nicht beschränkt am einfache Substraktionen.

18. Die Tastatur mit kapazitiven Tasten wie in R1, karakterisiert von:
Die Tastatur kan verbunden werden mittels ein reduzierter Drahtzähl, in diesem Zusammenhang 5, unabhänglich vom Anzahl der Tasten der Tastatur.

19. Die Tastatur mit kapazitiven Tasten wie in R1, karakterisiert von:
Die Tastenüberfläche kann reduziert werden bis C 5 cm2 ohne Leistungsänderung.

20. Die Tastatur mit kapazitiven Tasten wie in R1, karakterisiert von:
Der programmierte Mikrokontrolleur kann von einer Aktionslogik auf den Tasten abhängige Kommandiersignale hervorstellen.

21. Die Tastatur mit kapazitiven Tasten wie in R1, karakterisiert von:
Die Tastatur benützt eine elektronische Schaltung verbunden mit der Tastenoszillator von einem reduzierten Drahtanzahl und geeignet um ein Tastenanzahl von 1 bis 64 zu veranwalten bei einfache Änderung des Programs.

22. Die Tastatur mit kapazitiven Tasten wie in R1, karakterisiert von:
Die aktive Elektroden (Cnm) sind mekanisch desolidarisiert von der dielektrische Uberfläche und dessenhalb getrennt von dem Gebraucher. Dies gestattet eine einfache und unmittelbare Einstallazion der Anlage.

Fig 1

Fig 2

Fig 3

Fig 4

signal sélection

autre touche ---

HF

Figure 5

Figure 6